# EUROPÄISCHE PATENTSCHRIFT

(11) **EP 0 563 071 B1**
(45) Veröffentlichungstag und Bekanntmachung des Hinweises auf die Patenterteilung: **01.03.1995**
(21) Anmeldenummer: 91920731.6
(22) Anmeldetag: 03.12.1991
(51) Int. Cl.: H05K 9/00, H01R 13/658, B60R 21/00

(54) **GEGEN HF ABSCHIRMENDES GEHAÜSE EINER SCHALTUNG, Z.B. FÜR DIE STEUERSCHALTUNG EINES AIRBAG EINES FAHRZEUGES**
RF-SCREENING HOUSING FOR A CIRCUIT, E.G. FOR THE CONTROL CIRCUIT OF A MOTOR VEHICLE AIR-BAG
BOITIER DE PROTECTION CONTRE LES RADIOFREQUENCES POUR UN CIRCUIT, PAR EXEMPLE POUR LA COMMANDE D'UN "AIRBAG" D'UN VEHICULE

(30) Priorität: 21.12.1990 DE 9012528 U
(43) Veröffentlichungstag der Anmeldung: 06.10.1993
(73) Patentinhaber: SIEMENS AKTIENGESELLSCHAFT, 80333 München (DE)
(72) Erfinder: PLANKL, Christian, Dipl.-Ing. (TU), D-8411 Fussenberg (DE); GRUBER, Robert, Dipl.-Ing. (FH), D-8403 Bad Abbach (DE); DIRMEYER, Josef, Dipl.-Ing. (FH), D-8465 Bodenwöhr (DE)
(86) Internationale Anmeldenummer: EP9102282
(87) Internationale Veröffentlichungsnummer: WO9211745

(56) Entgegenhaltungen:
- EP-A- 0 385 689
- DE-A- 2 216 333
- DE-A- 2 813 457
- DE-U- 9 013 539
- RESEARCH DISCLOSURE Nr. 313, Mai 1990, EMSWORTH GB Seite 416; ANONYMUS: 'electronic assembly cover method'

## Beschreibung

### Gegen HF abschirmendes Gehäuse einer Schaltung, z.B. für die Steuerschaltung eines Airbag eines Fahrzeuges

Die Erfindung geht von dem im Oberbegriff des Patentanspruches 1 definierten Gegenstand aus, der für sich dem Fachmann, besonders auch dem Fachmann für Kraftfahrzeugelektronik, vielfach vorbekannt ist.

Die Erfindung betrifft also die Abschirmung von Schaltungen gegen auf sie von außen einwirkende HF-Störungen. Die Erfindung betrifft ebenso die Eindämmung von HF-Störungen, welche von der Schaltung ausgehen und auf die Umgebung einwirken.

Die Erfindung wurde zwar zunächst für das weitgehend in der Lenkradnabe unterzubringende Airbagsystem eines KFZ entwikkelt, welches der WO 91/14 601 entspricht. Es zeigte sich aber, daß die Erfindung auch auf andere Airbagsysteme, und sogar darüber hinaus auch auf alle sonstigen, unter den Oberbegriff des Patentanspruches 1 fallende Anordnungen anwendbar ist.

Bei einem bekannten Gehäuse (DE-U 90 13 539) zum Abschirmen einer Schaltung ist ein Stecker in der Gehäusewand angeordnet. Der Stecker ist über Verbinder mit der Schaltung verbunden. Das Gehäuse des Steckers wird mit einem ihn umgebenden Metallschild gegen HF abgeschirmt. Durch Federzungen des Metallschildes, die gegen das Gehäuse drücken, wird der elektrische Kontakt zum Gehäuse verbessert.

Dabei sind allerdings die Verbinder innerhalb des Gehäuses nicht oder nur teilweise abgeschirmt und können die Schaltung durch HF-Strahlung beeinträchtigen.

Ein weiteres bekanntes Gehäuse (Research Disclosure, No. 313, May 1990, Emsworth, GB) weist einen Deckel und einen Boden auf, zwischen die im montierten Zustand eine eine Schaltung tragende Leiterplatte eingeklemmt ist. Die Stoßstellen zwischen Deckel oder Boden und der Leiterplatte sind mit Zinn beschichtet, um die HF-Abschirmwirkung des Gehäuses zu verbessern.

Ein besonderes Problem solcher Gehäuse, ihrer Stecker und ihrer Leiterplatten - besonders bei Airbagsystemen - ist die Massenfertigung, und zwar die möglichst zuverlässige, leichte Herstellung der Bestandteile und deren anschließende, einfache und zuverlässige Montage, wobei aber die Abschirmwirkungen nicht darunter leiden dürfen.

Die Aufgabe,
- mit relativ wenig Aufwand die zuverlässige, relativ leicht beherrschbare Massenfertigung erreichen zu können,
- z.B. eine zuverlässige und trotzdem aufwandsarme Massenfertigung der gegen HF-Störungen abgeschirmten Airbag-Steuerschaltungen von Kraftfahrzeugen erreichen zu können,

wird erfindungsgemäß durch den im Patentanspruch 1 definierten Gegenstand gelöst.

Die in den Unteransprüchen definierten Gegenstände gestatten, zusätzliche Vorteile zu erreichen. U.a. gestatten nämlich die zusätzlichen Maßnahmen gemäß dem Patentanspruch
- 2,: die Abschirmung im Bereich der offenen Seitenfläche noch weiter zu verbessern,
- 3,: ohne großen Montageaufwand beim Montieren der betreffenden Bestandteile die Leiterplatte zwischen der Bodenwanne und dem Deckel möglichst spaltfrei und damit gegen HF-Störungen abgedichtet befestigen zu können,
- 4,: ohne großen Herstellungsaufwand beim Herstellen der betreffenden Bestandteile und ohne großen Montageaufwand beim anschließenden Montieren dieser Bestandteile die Leiterplatte zwischen der Bodenwanne und dem Dekkel möglichst spaltfrei und damit gegen HF-Störungen abdichtend befestigen zu können, sowie
- 5,: ohne großen Herstellungsaufwand beim Herstellen der betreffenden Schulterfläche und ohne zusätzlichen Montageaufwand beim anschließenden Montieren der betreffenden Bestandteile die Leiterplatte zwischen der Bodenwanne und dem Deckel besonders gut spaltfrei und damit gegen HF-Störungen besonders gut abdichtend befestigen zu können.

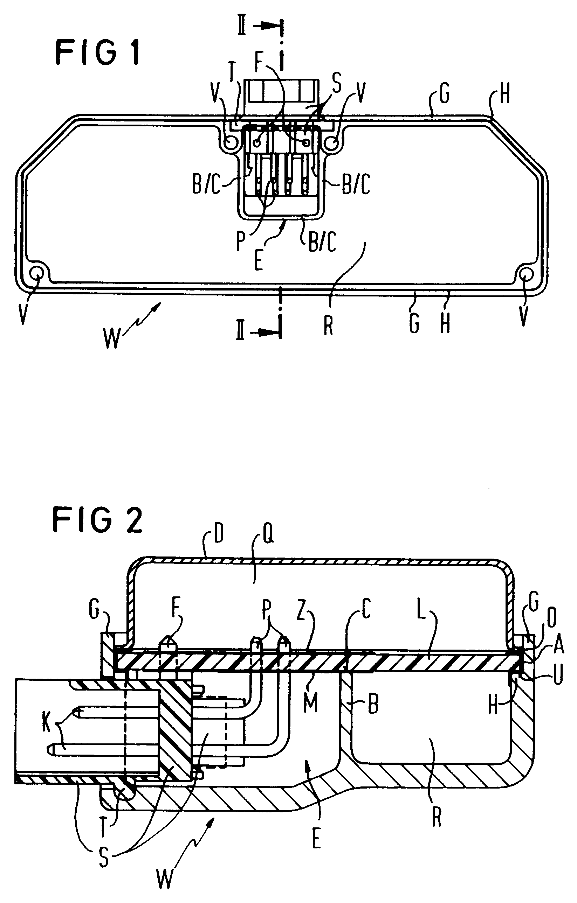

Die Erfindung und Weiterbildungen derselben werden anhand eines in den beiden Figuren gezeigten Ausführungsbeispieles der Erfindung weiter erläutert, welches der Übersichtlichkeit wegen durch Weglassen weniger wichtiger Details möglichst einfach dargestellt wurde. Dabei zeigt die Figur
- 1: eine Draufsicht auf die Bodenwanne, bevor auf ihr die Leiterplatte und der Deckel aufgebracht wurde, sowie
- 2: in etwas verändertem Maßstab einen Schnitt durch die in der Figur 1 gezeigte Bodenwanne, jedoch nachdem die Leiterplatte und der Deckel bereits aufgebracht wurde.

Beide Figuren zeigen also zwei verschiedene Ansichten ein und desselben Beispiels der Erfindung, also ein gegen HF abschirmendes mehrteiliges - und zwar hier zweiteiliges, vgl. W und D - metallisches oder mit Metall beschichtetes Gehäuse W/D einer Schaltung. Die Schaltung stellt z.B. die Steuerschaltung eines Airbag eines Fahrzeuges dar. Das Gehäuse W/D besteht hier im wesentlichen aus der Bodenwanne W und dem Deckel D, wobei diese beiden Bestandteile W und D mit relativ wenig Aufwand auch mittels Alu-Druckguß hergestellt werden können, z.B. um auch die bei einem Crash unbedingt nötige Stabilität des Gehäuses W/D zu erreichen.

Die Figur 2 zeigt, daß bei diesem Beispiel im Gehäuse W/D die Leiterplatte L so eingefügt ist, daß sie bei diesem Beispiel sogar die ganze, in der Figur 1 gezeigte Bodenwanne W abdeckt. Die Leiterplatte L liegt nämlich auf der Schulterfläche H auf, welche innen am Rand der Bodenwanne W weitgehend rundum umläuft, vgl. die in den beiden Figuren gezeigte Schulterfläche H. Diese Leiterplatte L trägt zumindest einen Teil der betreffenden Schaltung, deren einzelne Bestandteile bei diesem Beispiel der Erfindung sowohl in den Innenraum R der Bodenwanne W als auch in den Innenraum Q des Deckels D hineinragen können. Der Deckel D ist so geformt, daß er die Leiterplatte L abdeckt und daß seine Deckelkante gerade noch in die Umrandung G der Bodenwanne W hineinpaßt.

Beide Figuren zeigen auch den von der Gehäusewand W gehaltenen - hier einzigen - Stecker S, welcher z.B. im wesentlichen aus isolierendem Kunststoff und seinen nach außen gerichteten Steckerstiften K besteht. Im gezeigten Beispiel ist der Stecker S mittels angespritzter Kunststoffzapfen F an der Leiterplatte L befestigt. Im Prinzip können übrigens auch mehrere solche Stecker S in erfindungsgemäßer Weise am Gehäuse W/D angebracht sein. Der gezeigte Stecker S ist mit seitlichen Kunststoffrippen T in entsprechende spaltförmige Schächten der Bodenwanne W gesteckt und dadurch von der Bodenwanne W stabil gehalten. Dieser Stecker S besitzt auf seiner Rückseite die in die Leiterplatte L eingelöteten, innere Steckeranschlüsse bildenden Pins P, welche die elektrische Verbindung zwischen der Schaltung einerseits und - im Prinzip beliebigen - elektrischen Teilen außerhalb des Gehäuses W/D andererseits herstellen und welche bei Bedarf zur Entstörung, z.B. mittels Dämpfungskondensatoren, für sich als HF-Filter aufgebaut sein können. Diese außerhalb des Gehäuses W/D liegenden Teile können z.B. zur Stromversorgung der Schaltung dienen und/oder zu Prüf- und Anzeigezwecken. Sie können zusätzlich oder alternativ auch zu anderen Zwecken dienen, - also z.B. auch zum Zünden eines Explosivstoffes, um schlagartig das Gas für einen Airbag zu erzeugen.

Ein Hauptziel der Erfindung ist, das Gehäuse W/D, seinen Stecker S und seine Leiterplatte L zuverlässig und mit wenig Aufwand in Massenfertigung herstellen zu können, und anschließend ebenso zuverlässig und möglichst narrensicher alles montieren zu können, ohne daß darunter die Abschirmwirkung leidet. Besonders schwierig und wichtig ist hierbei die Art der Anbringung des Steckers S, wobei die erforderliche Abschirmwirkung unbedingt auch im Steckerbereich erreicht werden muß.

Die Erfindung zeigt dazu einen neuen Weg, wobei bei der Erfindung der Stecker S, vgl. auch die beiden Figuren, im wesentlichen aus Isoliermaterial bestehen kann, also selbst gar keine Abschirmwirkung ausübt. - Die Erfindung läßt aber zu, daß man zusätzlich im und/oder am Stecker S selbst die für ihn bekannten Abschirmmaßnahmen, z.B. Metalleinlagen oder Metallbeschichtungen, anbringen kann. Versuche zeigten aber, daß es bei der Erfindung im allgemeinen selbst unter den strengen Bedingungen bei Airbagsteuerungen ausreicht, den Stecker S im wesentlichen nur aus einem isolierenden Kunststoff herzustellen, z.B. durch Spritzguß, weil die erfindungsgemäßen Maßnahmen bereits eine hohe Abschirmwirkung zu erreichen gestatten.

Zur zuverlässigen Abschirmung gegen HF auch im Bereich des Steckers S weist nämlich die Bodenwanne W, also das erste Gehäuseteil W, eine Bucht E mit metallischen oder mit Metall beschichteten Wänden B auf. Im montierten Zustand des Gehäuses W/D liegen also diese Wände B der Bucht E, bzw. deren Metallbeschichtungen, auf Gehäusepotential, also z.B. auf Erdpotential.

Bei der Erfindung ist die Bucht E/B an nur einer einzigen ihrer Seitenflächen,genannt die "offene Seitenfläche", zum Gehäuseinneren Q hin offen, und zwar in der Weise, daß die Bucht E/B in einer einzigen Ebene liegende, zur offenen Seitenfläche gewandte Kanten C aufweist, wobei diese Kanten C der Bucht E/B auf dem Potential der betreffenden metallischen bzw. mit Metall beschichteten Wände B der Bucht E/B, im montierten Zustand des Gehäuses W/D also auf Gehäusepotential liegen.

Diese offene Seitenfläche ist im montierten Zustand des Gehäuses W/D bei der Erfindung von einem Abschnitt der Leiterplatte L abgedeckt. Die Leiterplatte L ist hierbei an ihrem der Bucht E/B zugewandten, die Steckeranschlüsse P enthaltenden Leiterplattenabschnitt großflächig mit einer leitenden Schicht M so bedeckt, daß Streifen dieser Schicht M im montierten Zustand des Gehäuses W/D auf den Kanten C der Bucht E/B aufliegen, so daß die Schicht M die Bucht E/B abdeckt, - wobei im montierten Zustand des Gehäuses W/D die Schicht M ebenfalls auf dem Gehäusepotential liegt.

Durch diese Abdeckung der offenen Seitenfläche der Bucht E/B mit der Schicht M der Leiterplatte L wird die erfindungsgemäß angestrebte Abdichtung der Schaltung gegen HF-Störungen auch im Steckerbereich erreicht, selbst wenn der Stecker S selber im wesentlichen aus isolierendem Kunststoff besteht, also für HF-Störungen durchlässig ist. Durch die Erfindung wird also mit relativ wenig Aufwand die angestrebte zuverlässige, relativ leicht beherrschbare Massenfertigung erreichbar, also z.B. auch jene zuverlässige und trotzdem aufwandsarme Massenfertigung der gegen HF-Störungen abgeschirmten Airbag-Steuerschaltungen von Kraftfahrzeugen.

Man kann die Abschirmung im Bereich der offenen Seitenfläche noch weiter verbessern, indem man auf der und/oder in der Leiterplatte L, und zwar an ihrem der Bucht E/B zugewandten, die Steckeranschlüsse P enthaltenden Leiterplattenabschnitt, in mindestens einer weiteren Leiterplattenebene großflächig jeweils eine weitere leitende Schicht Z anbringt, vgl. Z, welche man im späteren Betrieb, also im montierten Zustand des Gehäuses W/D, auf einem gegenüber dem Gehäusepotential konstanten Potential legt, - also z.B. ebenfalls auf das Gehäusepotential oder auf eine entsprechende Gleichspannung, wobei dann im montierten Zustand des Gehäuses W/D mehrere leitende, übereinander liegende Schichten M, Z die Bucht E/B großflächig abdecken und eine besonders gute HF-Abschirmung im Bereich der offenen Seitenfläche der Bucht E/B gewährleisten.

Man kann ohne großen Aufwand die Leiterplatte zwischen der Bodenwanne und dem Deckel praktisch spaltfrei montieren und damit gegen HF-Störungen abgedichtet befestigen, wenn man die Leiterplatte L zumindest weitgehend wenn nicht rundum am ihrem Umfang U-förmig mit Metall beschichtet ist, vgl. O/A/U in der Figur 2. Dazu ist also die Leiterplatte L sowohl längs ihrer Außenkante A mit Metall beschichtet, als auch, leitend mit der Außenkante A verbunden, auf ihren beiden, an die Außenkante A seitlich unmittelbar angrenzenden (in der Figur 2 : oberen und unteren) Randstreifen O, U mit Metall beschichtet. Günstig für dieser praktisch spaltfreie Montage außerdem, der Leiterplatte L einen solchen Umriß A zu geben, daß die Leiterplatte L an ihrem ersten (in der Figur 2 : unteren) Randstreifen U im montierten Zustand des Gehäuses W/D möglichst dicht auf einer in der Bodenwanne W umlaufenden Schulterfläche, vgl. H in den beiden Figuren, aufliegt, wobei diese Schulterflächen H dann auf Gehäusepotential liegen. Die Leiterplatte L kann übrigens z.B. mittels Schrauben, vgl. die Gewindebohrungen V in der Figur 1, fest auf die in beiden Figuren gezeigten Kanten C und Schulterflächen H gedrückt sein. Günstig ist ferner, den Deckel D so zu formen, daß die Leiterplatte L an ihrem zweiten (in der Figur 2 : oberen) Randstreifen O möglichst dicht mit der betreffenden Randkante des Deckels D abgedeckt ist. Dabei kann übrigens auch der Deckel D mittels der gezeigten Schrauben V auf die Leiterplatte L gedrückt sein.

Um ohne großen Herstellungsaufwand beim Herstellen der betreffenden Bestandteile und ohne großen Aufwand beim anschließenden Montieren dieser Bestandteile die Leiterplatte L zwischen der Bodenwanne W und dem Deckel D möglichst spaltfrei und damit gegen HF-Störungen abgedichtet befestigen zu können, kann man zusätzlich die verschiedenen mit Metall beschichteten Streifen, vgl. C, O, U, der Leiterplatte L, an welchen, vgl. C, die Leiterplatte L auf den Kanten C der Bucht E/B aufliegt und/oder an welchen, vgl. O, U, die Leiterplatte L längs ihres Umfanges A Gehäuseteile, vgl. H, D, berührt, an diesen Streifen dick mit Lötmasse, z.B. mit Zinn, überziehen. Dann wird nämlich bei der Montage die weiche, nachgebende Lötmasse besonders dicht an die betreffenden Kanten der Gehäuseteile gedrückt und damit besonders spaltfrei abgedichtet, vgl. C hinsichtlich der Wände der Bucht E/B - und vgl. W/H und D einerseits hinsichtlich des Randstreifens U, welcher dann dick mit Lötmasse bedeckt ist und die Schulterfläche H berührt, und hinsichtlich des Randstreifens O, welcher dann ebenfalls dick mit Lötmasse bedeckt ist und die Randkante des Deckels D berührt.

Diese zuletzt genannte Maßnahme, nämlich das dicke Bedecken der betreffenden Streifen der Leiterplatte L mit Lötmasse, kann zusätzlich durch ein geschicktes Präparieren des betreffenden, von der Lötmasse berührten Kanten ergänzt werden, um die Leiterplatte L zwischen den Wänden B der Bucht E/B und/oder zwischen der Bodenwanne W und dem Deckel D besonders gut spaltfrei und damit gegen HF-Störungen besonders gut abzudichten; und zwar gelingt dies ohne großen zusätzlichen Herstellungsaufwand beim Herstellen der betreffenden Schulterflächen H und ohne zusätzlichem Montageaufwand beim anschließenden Montieren der betreffenden Bestandteile L, W, D : Dazu kann man nämlich die Kanten C und/oder Schulterflächen H zumindest einzelner W der Gehäuseteile W, D, welche im montierten Zustand des Gehäuses W/D von der Lötmasse unter Druck, z.B. durch Verschrauben (V), berührt werden, aufrauhen. Dann wird nämlich die weiche Lötmasse unter diesem Druck in die aufgerauhten Kanten gedrückt, wodurch die Abdichtung besonders gut ist.

## Patentansprüche

1. Gegen hochfrequente Strahlung abschirmendes metallisches oder mit Metall beschichtetes Gehäuse (W/D), insbesondere für die Steuerschaltung eines Airbag eines Kraftfahrzeugs, mit
- einem ersten Gehäuseteil (W) und einem zweiten Gehäuseteil (D),
- einer in dem Gehäuse (W/D) anzubringenden, zumindest einen Teil einer Schaltung tragenden Leiterplatte (L), und
- einem von der Gehäusewand des ersten Gehäuseteils (W) gehaltenen Stecker (S), welcher über in der Leiterplatte (L) angebrachte Steckeranschlüsse (P) die Verbindung zwischen der Schaltung einerseits und elektrischen Teilen außerhalb des Gehäuses (W/D) andererseits herstellt,
**dadurch gekennzeichnet,**
- daß das erste Gehäuseteil (W) eine Bucht (E/B) aufweist, welche metallische oder mit Metall beschichtete, im montierten Zustand des Gehäuses (W/D) auf Gehäusepotential liegende Wände (B) besitzt und in welchem der Stecker (S) und dessen zur Schaltung hin gerichteten Steckeranschlüsse (P) angeordnet sind, wobei die Bucht (E/B), die nur an einer einzigen ihrer Seitenflächen zum Gehäuseinneren (Q) hin offen ist, in einer einzigen Ebene liegende, zur offenen Seitenfläche gewandte Kanten (C) aufweist, auf denen im montierten Zustand des Gehäuses (W/D) die offene Seitenfläche abdeckende Leiterplatte (L) angeordnet ist, und
- daß die Leiterplatte (L) an ihrem der Bucht (E/B) zugewandten, die Steckeranschlüsse (P) enthaltenden Leiterplattenabschnitt großflächig mit einer elektrisch leitenden Schicht (M) so bedeckt ist, daß Streifen dieser Schicht (M) im montierten Zustand des Gehäuses (W/D) auf den Kanten (C) der Bucht (E/B) aufliegen, so daß dann die Schicht (M) die Bucht (E/B) abdeckt und dann die Schicht (M) auf dem Gehäusepotential liegt.

2. Gehäuse nach Anspruch 1, dadurch gekennzeichnet, daß die Leiterplatte (L) an ihrem der Bucht (E/B) zugewandten, die Steckeranschlüsse (P) enthaltenden Leiterplattenabschnitt in mindestens einer weiteren Leiterplattenebene großflächig jeweils eine weitere leitende Schicht (Z) aufweist, welche im montierten Zustand des Gehäuses (W/D) auf einem gegenüber dem Gehäusepotential konstanten Potential liegt, wobei im montierten Zustand des Gehäuses (W/D) mehrere leitende, übereinander liegende Schichten (M, Z) die Bucht (E/B) großflächig abdecken.

3. Gehäuse nach Anspruch 1 dadurch gekennzeichnet,
- daß die Leiterplatte (L) zumindest teilweise an ihrem Umfang (O/A/U) U-förmig mit Metall beschichtet ist, und zwar sowohl längs der Außenkante (A) der Leiterplatte (L) mit Metall beschichtet ist als auch, leitend mit der Außenkante (A) verbunden, auf dem an die Außenkante (A) seitlich unmittelbar angrenzenden Randstreifen (O, U) der Leiterplatte (L) mit Metall beschichtet ist,
- daß die Leiterplatte (L) einen solchen Umriß (A) aufweist, daß sie an ihrem ersten Randstreifen (U) im montierten Zustand des Gehäuses (W/D) möglichst dicht auf einer in dem ersten Gehäuseteil (W) umlaufenden, dann auf Gehäusepotential liegenden Schulterfläche (H) aufliegt, und
- daß die Leiterplatte (L) an ihrem zweiten Randstreifen (O) möglichst dicht mit einer Randkante des Deckels (D) abgedeckt ist.

4. Gehäuse nach Anspruch 3, dadurch gekennzeichnet, daß die mit Metall beschichteten Streifen (bei C, O, U) der Leiterplatte (L), an welchen die Leiterplatte (L) auf den Kanten (C) der Bucht (E/B) aufliegt und/oder an welchen die Leiterplatte (L) längs ihres Umfanges (A) Gehäuseteile (W/H, D) berührt, mit Lötmasse dick überzogen sind.

5. Gehäuse nach Anspruch 4, dadurch gekennzeichnet, daß die Kanten (C) und/oder Schulterflächen (H) zumindest einzelner der Gehäuseteile (W, D), welche im montierten Zustand des Gehäuses (W/D) von der Lötmasse unter Druck berührt werden, aufgerauht sind.

## Claims

1. Metallic or metal-coated housing (W/D), in particular for the air-bag control circuit of a motor vehicle, which provides screening against radio-frequency radiation, having
- a first housing section (W) and a second housing section (D),
- a printed circuit board (L) to be mounted in the housing (W/D) and supporting at least a part of a circuit, and
- a plug (S) which is held by the housing well of the first housing section (W) and which makes, via plug terminals (P) provided in the printed circuit board (L), the connection between the circuit, on the one hand, and electrical parts situated outside the housing (W/D), on the other hand,
characterized
- in that the first housing section (W) has a bay (E/B) which has metallic or metal-coated walls (B) which are at housing potential in the assembled state of the housing (W/D) and in which the plug (S) and its plug terminals (P) directed towards the circuit are arranged, the bay (E/B), which is open only at one of its side faces facing the inside (Q) of the housing, having edges (C) which lie in a single plane and face the open side face and on which the printed circuit board (L), which covers the open side face, in the assembled state of the housing (W/D) is mounted, and
- in that the printed circuit board (L) is coated over a large area of its section facing the bay (E/B) and containing the plug terminals (P) with an electrically conducting layer (M) in such a way that strips of said layer (M) rest on the edges (C) of the bay (E/B) in the assembled state of the housing (W/D) so that the layer (M) then covers the bay (E/B) and the layer (M) is then at housing potential.

2. Housing according to Claim 1, characterized in that the printed circuit board (L) has a further conducting layer (Z), which is connected in the assembled state of the housing (W, D) to potential which is constant with respect to the housing potential, in each case over a large area in at least one further printed circuit board level on the printed circuit board section facing the bay (E/B) and containing the plug terminals (P), a plurality of conducting layers (M, Z) situated one above the other covering the bay (E/B) over a large area in the assembled state of the housing (W, D).

3. Housing according to Claim 1, characterized
- in that the printed circuit board (L) is metal-coated, at least partly, at its circumference (O/A/U) in a U shape and, in particular, is metal-coated both along the outside edge (A) of the printed circuit board (L) and is also metal-coated on the edge strips (O, U) of the printed circuit board (L) immediately adjacent laterally to the outside edge (A) and conductingly connected to the outside edge (A),
- in that the printed circuit board (L) has a contour (A) which is such that the first edge strip (U) of the printed circuit board rests as tightly as possible, in the assembled state of the housing (W/D), on a shoulder face (H) which extends around the first housing section (W) and is then at housing potential, and
- in that the second edge strip (O) of the printed circuit board (L) is covered as tightly as possible with a peripheral edge of the lid (D).

4. Housing according to Claim 3, characterized in that the metal-coated strips (at C, O, U) of the printed circuit board (L) at which the printed circuit board (L) rests on the edges (C) of the bay (E/B) and/or at which the printed circuit board (L) makes contact with housing sections (W/H, D) along its circumference (A) is thickly coated with soldering material.

5. Housing according to Claim 4, characterized in that the edges (C) and/or shoulder faces (H) at least of individual parts of the housing sections (W, D) which are contacted in the assembled state of the housing (W/D) by the soldering material under pressure are roughened.

## Revendications

1. Boîtier métallique ou revêtu d'un métal (W/D), protégeant d'un rayonnement à haute fréquence, notamment pour le circuit de commande d'un coussin d'air d'un véhicule automobile, comportant
- une première partie (W) et une seconde partie (D) du boîtier,
- une plaquette à circuits imprimés (L), qui doit être montée dans le boîtier (W/D) et qui porte au moins une partie d'un circuit, et
- un connecteur (S), qui est retenu par la paroi de la première partie (W) du boîtier et qui établit, par l'intermédiaire de bornes (P) disposées dans la plaquette à circuits imprimés (L), la liaison entre le circuit d'une part et des parties électriques à l'extérieur du boîtier (W/D) d'autre part,
caractérisé par le fait
- que la première partie (W) du boîtier comporte une baie (E/B), qui possède des parois métalliques ou revêtues de métal (B), qui sont placées au potentiel du boîtier (W/D) lorsque ce dernier est à l'état monté, et dans laquelle sont disposés le connecteur (S) et ses bornes (P) orientées en direction du circuit, la baie (E/B), qui est ouverte uniquement sur une seule de ses surfaces latérales en direction de l'intérieur (Q) du boîtier, ayant des bords (C) qui sont situés dans un plan
unique et sont tournés vers la surface latérale ouverte et sur lesquels la plaquette à circuits imprimés (L), qui recouvre la surface latérale ouverte, est disposée lorsque le boîtier (W/D) est à l'état monté, et
- que la plaquette à circuits imprimés (L) est recouverte sur une grande surface, dans sa partie tournée vers la baie (E/B) et contenant les bornes (P) du connecteur, d'une couche électriquement conductrice (M), de telle sorte que, lorsque le boîtier (W/D) est à l'état monté, des bandes de cette couche (M) s'appliquent sur les bords (C) de la baie (E/B) si bien qu'alors la couche (M) recouvre la baie (E/B) et est alors placée au potentiel du boîtier.

2. Boîtier suivant la revendication 1, caractérisé par le fait que la plaquette à circuits imprimés (L) comporte sur une grande surface, dans sa partie tournée vers la baie (E/B) et qui contient les bornes (P) du connecteur, et ce dans au moins un autre plan de la plaquette à circuits imprimés, une autre couche conductrice (Z), qui lorsque le boîtier (W/D) est à l'état monté, est placée à un potentiel constant par rapport au potentiel du boîtier, plusieurs couches conductrices superposées (M,Z) recouvrant, lorsque le boîtier (W/D) est à l'état monté, la baie (E/B) sur une grande surface.

3. Boîtier suivant la revendication 1, caractérisé en ce
- que la plaquette à circuits imprimés (L) est revêtue sous la forme d'un U d'un métal, au moins partiellement sur sa périphérie (O/A/U) et ce en étant à la fois revêtue de métal le long du bord extérieur (A) de la plaquette à circuits imprimés(L), et, en étant reliée d'une manière conductrice au bord extérieur (A), de métal situé sur la bande marginale (O,U), immédiatement adjacente latéralement au bord extérieur (A), de la plaquette à circuits imprimés (L),
- que la plaquette à circuits imprimés (L) à un contour (A) qui, lorsque le boîtier (W/D) est à l'état monté, s'applique, d'une manière aussi étanche que possible, par sa première bande marginale (U) sur une surface d'épaulement (H), qui s'étend circonférentiellement dans la première partie (W) du boîtier et est alors placée au potentiel du boîtier, et
- que la plaquette à circuits imprimés (L) est recouverte, au niveau de sa seconde bande marginale (E), d'une manière aussi étanche que possible, par un bord marginal du boîtier (D).

4. Boîtier suivant la revendication 3, caractérisé par le fait que des bandes (en C, O, U) de la plaquette à circuits imprimés (L), qui sont revêtues de métal, et par lesquelles cette plaquette s'applique sur les bords (C) de la baie (E/B) et/ou au niveau desquels la plaquette à circuits imprimés (L) touche, le long de sa périphérie (A), des parties (W/H,D) du boîtier, sont recouvertes en une grande épaisseur d'un agent à braser.

5. Boîtier suivant la revendication 4, caractérisé en ce que les bords (C) et/ou les surfaces d'épaulement (H) au moins de certaines parties (W,D) du boîtier, contre laquelle l'agent à braser s'applique sous pression lorsque le boîtier (W/D) est à l'état monté, sont rugueux.
